# NEW EUROPEAN PATENT SPECIFICATION

(11) **EP 3 228 490 B2**
(45) Date of publication and mention of the opposition decision: **15.01.2025**
(45) Mention of the grant of the patent: 18.12.2019
(21) Application number: 17152507.4
(22) Date of filing: 20.01.2017
(51) Int. Cl.: B60L 1/00, B60L 3/00, H01L 23/34, H02M 7/00, H05K 7/20

(54) **POWER CONVERSION DEVICE**
STROMWANDLUNGSVORRICHTUNG
DISPOSITIF DE CONVERSION D'ALIMENTATION ÉLECTRIQUE

(30) Priority: 30.03.2016 JP 2016067033
(43) Date of publication of application: 11.10.2017
(73) Proprietor: Hitachi, Ltd., Chiyoda-ku, Tokyo 100-8280 (JP)
(72) Inventor: YASUDA, Yosuke, Chiyoda-ku, Tokyo 100-8280 (JP); KATAGIRI, Masaru, Chiyoda-ku, Tokyo 100-8280 (JP); MAE, Kentarou, Chiyoda-ku, Tokyo 100-8280 (JP); NISHIMURA, Yoshitaka, Chiyoda-ku, Tokyo 100-8280 (JP); YAMAUCHI, Takahiro, Chiyoda-ku, Tokyo 100-8280 (JP)
(74) Representative: Mewburn Ellis LLP

(56) References cited:
- EP-A1- 2 441 639
- EP-A1- 2 838 188
- EP-A2- 1 881 590
- EP-A2- 2 149 973
- CA-A1- 2 848 252
- DE-C2- 19 524 115
- JP-A- 2004 328 838
- JP-A- 2005 287 214
- JP-A- H09 219 904
- JP-A- S62 299 474
- ANONYMOUS: "Wasserkühlung", WIKIPEDIA, 21 October 2015 (2015-10-21), Retrieved from the Internet <URL:https://de.wikipedia.org/w/index.php?title=Wasserkühlung&oldid=147228925>

## Description

### BACKGROUND OF THE INVENTION

The present invention relates particularly to a power conversion device which includes a system for cooling down a power conversion semiconductor element using a liquid.

A vehicle driving control device which controls power to a vehicle driving motor and a power conversion device such as an auxiliary power source device which controls power to an onboard electric facility such as air conditioner are provided below a floor of a railway vehicle. A semiconductor element which switches a current to convert AC/DC is provided in these power conversion device.

The semiconductor element generates heat at the time of energizing and switching. In a case where the semiconductor element is increased in temperature due to the heat, there is a concern that a conversion efficiency may be lowered and an element may be broken. Therefore, the semiconductor element is necessarily cooled down to fall within a predetermined temperature range. Since the power conversion device is mainly mounted below a floor of the vehicle where a mounting space is limited, there is a need to efficiently cool down a plurality of semiconductor elements using a small device configuration. In particular, in a case where a large amount of power conversion is required for a high-speed vehicle, a liquid cooling system is used. As a configuration of the liquid cooling system, there is known a configuration disclosed in Japanese Patent No. 4,479,305.

The power conversion device disclosed in Japanese Patent No. 4,479,305 includes a first semiconductor electronic component and a second semiconductor electronic component which is separated from the first semiconductor electronic component. A first heat sink is provided in the first semiconductor electronic component to cool down the first semiconductor electronic component. A second heat sink is provided in the second semiconductor electronic component to cool down the second semiconductor electronic component. The first heat sink and the second heat sink are a type of liquid cooling heat sink in which a liquid refrigerant is supplied and circulated by a common radiator, an air blower, and a circulation pump. As a unit for adjusting a flow rate of the liquid refrigerant flowing to the first heat sink and the second heat sink, there is provided a control device which calculates a heat loss of the semiconductor electronic component on the basis of an operation state and adjust the flow rate of the liquid refrigerant, and a flow rate adjusting valve which adjusts a flow rate of the liquid refrigerant under control of the control device. With such a configuration, the flow rate of the liquid refrigerant can be adjusted according to the heat loss generated in each of the first semiconductor electronic component and the second semiconductor electronic component. Therefore, a cooling efficiency of the system can be improved, and the radiator and the circulation pump can be made small.

EP A 2149973 proposes a power conversion apparatus and electric vehicle.

JP2005287214 discloses a power converter mounted on a cooling device comprising several heat sinks.

### SUMMARY OF THE INVENTION

When a power conversion capacity of a power conversion device is increased, there is a need to increase a flow rate of the liquid refrigerant which is supplied to the heat sink in order to secure a cooling performance. Further, there is a need to increase a diameter of a pipe of the liquid refrigerant in order to reduce a pressure loss. In addition, when the power conversion capacity becomes large, there is also a need to increase a wire diameter as the current is increased. Furthermore, in a case where the device is configured by a plurality of power conversion circuits, the number of pipes and wires becomes large. Therefore, there is also a need to design the power conversion device to be more miniaturized in consideration of not only a radiator and a circulation pump but also an arrangement of pipes and wires.

In addition, the semiconductor electronic circuit component is necessarily replaced when it is out of order due to an overcurrent. Furthermore, the circulation pump is necessarily subject to the maintenance periodically. Therefore, there is a need to dispose the components in consideration of the device replacement and the easiness of the maintenance.

The invention has been made to solve the above problems, and an object thereof is to provide a power conversion device which is small and easy to maintain.

A power conversion device according to a first aspect of the invention for achieving the above object is provided by claim 1.

In the power conversion device in second aspect of the invention, the cooling device is configured by a radiator that cools down the liquid refrigerant, an air blower that supplies a cooling air to the radiator, a pump that circulates the liquid refrigerant, a distribution pipe that divides and supplies the liquid refrigerant to the plurality of power units, and a gathering pipe that receives the liquid refrigerant from the plurality of power units, the plurality of cooling-device-side pipe connectors are provided in the distribution pipe and the gathering pipe, and are provided in a bottom surface of the cooling device, the air blower is provided on a windward side of the radiator, and the cooling air is supplied from a side surface of the power conversion device to the radiator, passes through a space between the distribution pipe and the gathering pipe, and is discharged from a bottom surface of the power conversion device.

In the power conversion device in a third aspect of the invention, the plurality of cooling-device-side pipe connectors provided in the distribution pipe and the gathering pipe are disposed in a staggered pattern.

In the power conversion device in a fourth aspect of the invention, a valve for injecting or discharging the liquid refrigerant to the cooling device is provided in at least one place of a side surface and a bottom surface of the power conversion device.

In the power conversion device in a fifth aspect of the invention, the power conversion device is provided below a floor of a railway vehicle.

As described above, in a case where a power conversion capacity of a power conversion device is large and the device is configured by a plurality of power conversion circuits, the pipes and the wires are increased in diameter, and the number of pipes and wires is increased. According to the first aspect of the invention, it is possible to miniaturize the power conversion device by gathering the pipes and the wires occupying a large installation space in the center space of the device.

In addition, when the power conversion device is subjected to the maintenance, the power conversion device can be handled from the bottom surface thereof. According to the first aspect of the invention, a wire connector is provided in the bottom surface of a cooling device, and the pipe is connected to the wire connector through the lower portion of the space in a housing. Therefore, the pipe is easily detachably attached to the cooling device, and the cooling device is easily detachably attached to the housing, so that a maintenance performance can be improved.

In addition, the cooling air is desirably discharged from the bottom surface in order to extremely reduce a space where the cooling air passes in the power conversion device. According to the second aspect of the invention, the power conversion device can be miniaturized by effectively using the space in the cooling device.

According to the third aspect of the invention, the pipe is easily detachably attached to the bottom surface of the cooling device, so that the maintenance performance can be improved

According to the fourth aspect of the invention, the liquid refrigerant can be easily injected or discharged from the side surface of the bottom surface of the cooling device, so that the maintenance performance can be improved.

According to the first aspect of the invention, a power unit can be individually detachably attached, so that the maintenance performance can be improved.

The first to fourth aspect of the invention have a structure suitable to the power conversion device which is provided below the floor of a railway vehicle. According to the fifth aspect of the invention, it is possible to provide the power conversion device which is small and easy to maintain.

Other objects, features and advantages of the invention will become apparent from the following description of the embodiments of the invention taken in conjunction with the accompanying drawings.

### BRIEF DESCRIPTION OF THE DRAWINGS

FIG. 1 is a plan view illustrating a layout of components of a power conversion device according to a first embodiment of the invention;
FIG. 2 is a plan view illustrating a configuration of a cooling device which is mounted in the power conversion device according to the first embodiment of the invention and a pipe through which a liquid refrigerant is supplied to a power unit;
FIG. 3 is a plan view illustrating a configuration of the cooling device which is mounted in the power conversion device according to the first embodiment of the invention and a pipe through which the liquid refrigerant returns from the power unit to the cooling device;
FIG. 4 is a plan view illustrating a configuration of a main circuit wire for motor driving of the power conversion device according to the first embodiment of the invention;
FIG. 5 is a plan view illustrating a configuration of a main circuit wire for auxiliary power source of the power conversion device according to the first embodiment of the invention;
FIG. 6 is a diagram illustrating a pipe path of the power conversion device according to the first embodiment of the invention when viewed in a direction of arrow A of FIGS. 2 and 3;
FIG. 7 is a diagram illustrating a wire path of the power conversion device according to the first embodiment of the invention when viewed in a direction of arrow B of FIGS. 4 and 5;
FIG. 8 is a diagram illustrating a position of a wire connector of the cooling device which is mounted in the power conversion device according to the first embodiment of the invention when viewed from arrow C of FIGS. 2 and 3;
FIG. 9 is a plan view illustrating a configuration of a cooling device which is mounted in a power conversion device according to a second example of the invention; and
FIG. 10 is a cross-sectional view of a railway vehicle when viewed in an advancing direction.

### DESCRIPTION OF EMBODIMENTS

Hereinafter, embodiments of the invention will be described with reference to the drawings.

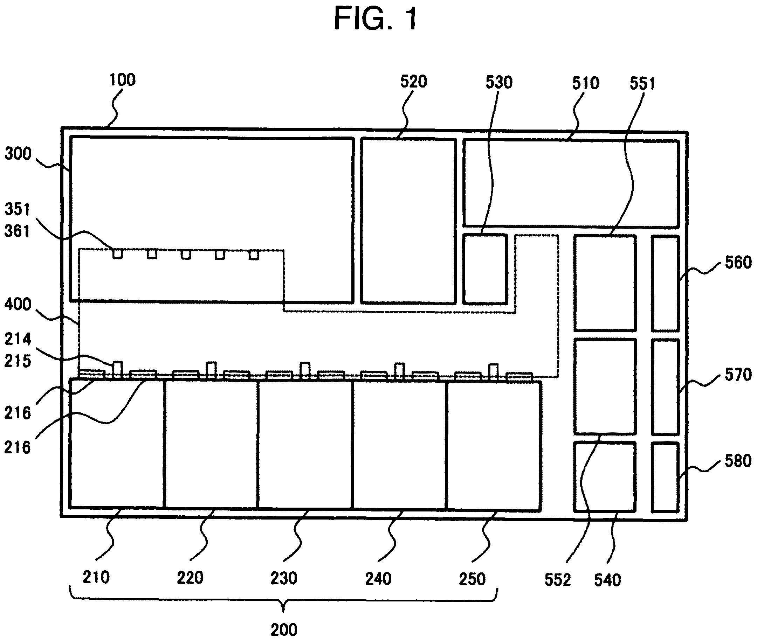

FIG. 1 is a plan view illustrating a layout of components of a power conversion device according to a first embodiment of the invention. A power conversion device 100 is configured by five power units 200, each of which includes a power conversion circuit, a cooling device 300 which supplies a liquid refrigerant to the power unit 200, a control device 510 which controls power conversion of the power unit 200, an AC reactor 520 which smoothes a three-phase alternating current output from the power unit, an AC capacitor 530 which smoothes a three-phase alternating voltage output from the power unit, a contactor 540 which disconnects a current when a ground fault occurs, a motor output core 551 which eliminates three-phase AC noises of the motor output, an auxiliary power source output core 552 which eliminates the three-phase AC noises of the auxiliary power source output, a motor output terminal 560, an auxiliary power source output terminal 570, and an input terminal 580. These components are provided on the side surfaces or the end portions of the power conversion device 100. A space 400 is provided in a portion surrounded by a dotted line in the center portion of the power conversion device 100 illustrated in FIG. 1.

A wire connector and a main circuit terminal of the power unit 200 will be described using a first power unit 210 as an example. In the first power unit 210, an inlet-side wire connector 214 through which the liquid refrigerant is supplied from the cooling device 300, an outlet-side wire connector 215 through which the liquid refrigerant returns to the cooling device 300, and a main circuit terminal 216 are provided at positions abutting on the space 400. The other power units 220, 230, 240, and 250 also have the same configuration.

In addition, a distributing-side wire connector 351 which supplies the liquid refrigerant to the power unit 200 and a gathering-side wire connector 361 which receives the liquid refrigerant from the power unit 200 are provided respectively at five places in the cooling device 300.

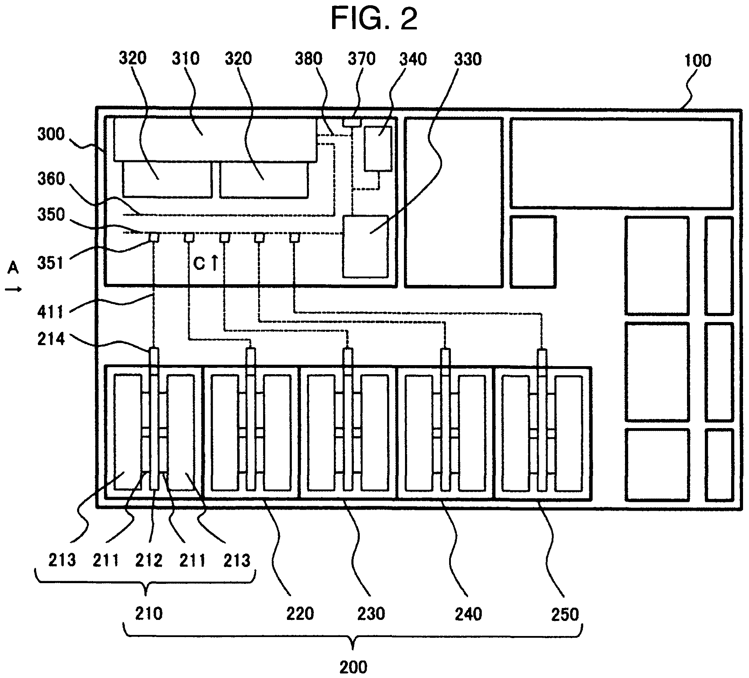

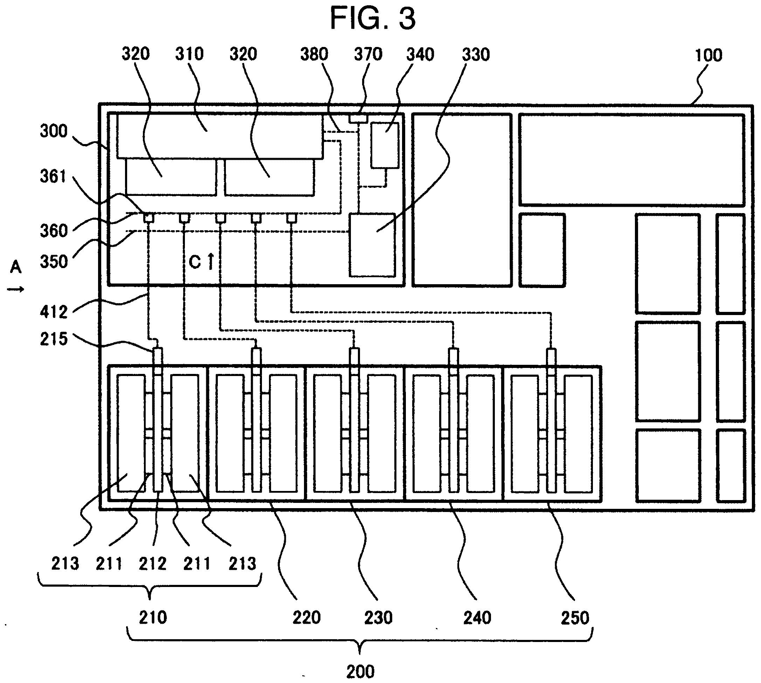

The description will be made about a configuration of a pipe through which the cooling device and the liquid refrigerant flow. FIG. 2 is a plan view illustrating a configuration of the cooling device which is mounted in the power conversion device according to the first embodiment of the invention and a pipe through which the liquid refrigerant is supplied to the power unit. In addition, FIG. 3 is a plan view illustrating a pipe through which the liquid refrigerant returns from the power unit to the cooling device. The cooling device 300 is configured by a radiator 310 which cools the liquid refrigerant, an air blower 320 which supplies a cooling air to the radiator 310, a pump 330 through which the liquid refrigerant is circulated, an expansion tank 340 which absorbs the expansion caused by a temperature rise of the liquid refrigerant, a distribution pipe 350 which supplies the liquid refrigerant to a plurality of power unit 200, a gathering pipe 360 which receives the liquid refrigerant from the plurality of power units 200, a valve 370 which performs injection and ejection of the liquid refrigerant, and the cooling device inner pipe 380 which connects these components. The liquid refrigerant is supplied from the pump 330 to the distribution pipe 350. Five distributing-side wire connectors 351 are provided in the distribution pipe 350, and the liquid refrigerant is distributed to five inlet-side pipes 411 through the distributing-side wire connector 351. The liquid refrigerant passed through the inlet-side pipe 411 is supplied from the inlet-side wire connector 214 to the power unit 200. The liquid refrigerant heated by the power unit 200 is supplied from the outlet-side wire connector 215 to an outlet-side pipe 412, and supplied to the gathering pipe 360 through the gathering-side wire connector 361. The liquid refrigerant is supplied from the gathering pipe 360 to the radiator 310, exchanges heat with respect to the cooling air supplied by the air blower 320 so as to be cooled down, and returns to the pump 330.

Next, the layout of the components in the cooling device 300 will be described. The radiator 310 is disposed on a side near a side surface of the power conversion device 100. Two air blowers 320 are provided in the rear surface of the radiator 310. The distribution pipe 350 and the gathering pipe 360 are disposed on the center side of the power conversion device 100. The valve 370 is disposed next to the radiator 310 in a direction toward the side surface of the power conversion device 100. The pump 330 is provided next to the distribution pipe 350 and the gathering pipe 360, and the expansion tank 340 is provided on a side near an inlet of the pump.

Next, the configuration of the power unit 200 will be described using the first power unit 210 as an example. The first power unit 210 is configured by a plurality of semiconductor elements 211 which convert the power by switching, a cooling plate 212 which includes a flow channel of the liquid refrigerant therein, and a filter capacitor 213 which smooths a main circuit voltage. The semiconductor element 211 is mounted on both surfaces of the cooling plate 212, and the filter capacitor 213 is provided on the outside of the semiconductor element 211. In other words, the semiconductor element 211 and the filter capacitor 213 are provided on both surface sides with the cooling plate 212 as the center. The inlet-side wire connector 214 and the outlet-side wire connector 215 are connected to the cooling plate 212, and communicate with the flow channel provided in the cooling plate 212, so that the flow channel of the liquid refrigerant is configured. In addition, the semiconductor element 211, the filter capacitor 213, and the main circuit terminal 216 are electrically connected to configure a main circuit of the first power unit 210. The other power units 220, 230, 240, and 250 also have the same configuration.

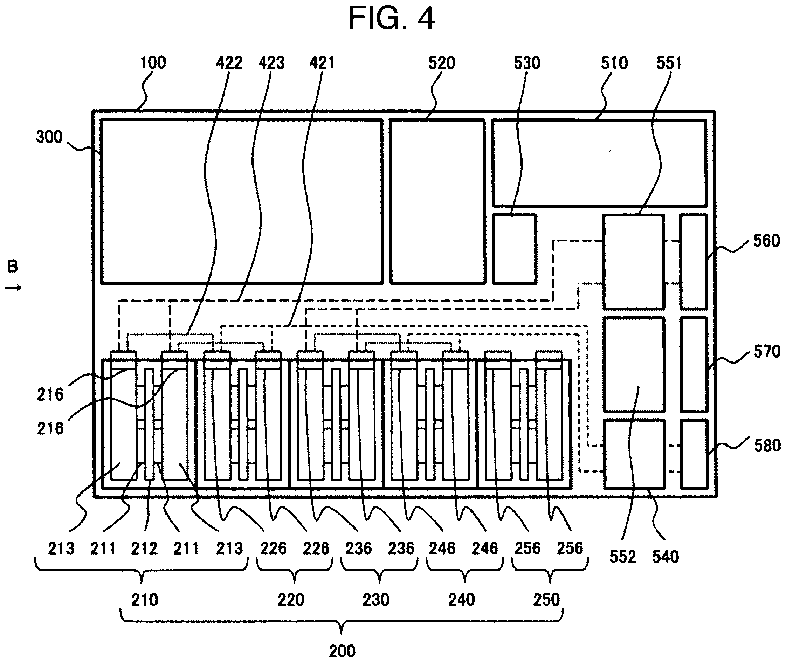

First, the description will be made about a configuration of a main circuit wire for motor driving. FIG. 4 is a plan view illustrating a configuration of a main circuit wire for motor driving of the power conversion device according to the first embodiment of the invention. A broken line 421 in the drawing indicates a single-phase AC wire, a dotted line 422 indicates a DC wire, and a long broken line 423 indicates a three-phase AC wire. The single-phase AC wire 421 is connected to main circuit terminals 226 and 246 of the second power unit 220 and the a fourth power unit 240 through the contactor 540 from the input terminal 580. The second power unit 220 and the fourth power unit 240 are converter circuits which convert a single-phase AC into a DC, and output the DC power to a DC wire 422. The main circuit terminals 226 and 246 of the second power unit 220 and the fourth power unit 240 are connected to the main circuit terminals 216 and 236 of the first power unit 210 and the third power unit 230 through the DC wire 422. The first power unit 210 and the third power unit 230 are inverter circuits which convert the DC into a three-phase AC, and outputs the three-phase AC power to a three-phase AC wire 423. The main circuit terminals 216 and 236 of the first power unit 210 and the third power unit 230 are connected to the motor output terminal 560 through the three-phase AC wire 423 and the motor output core 551.

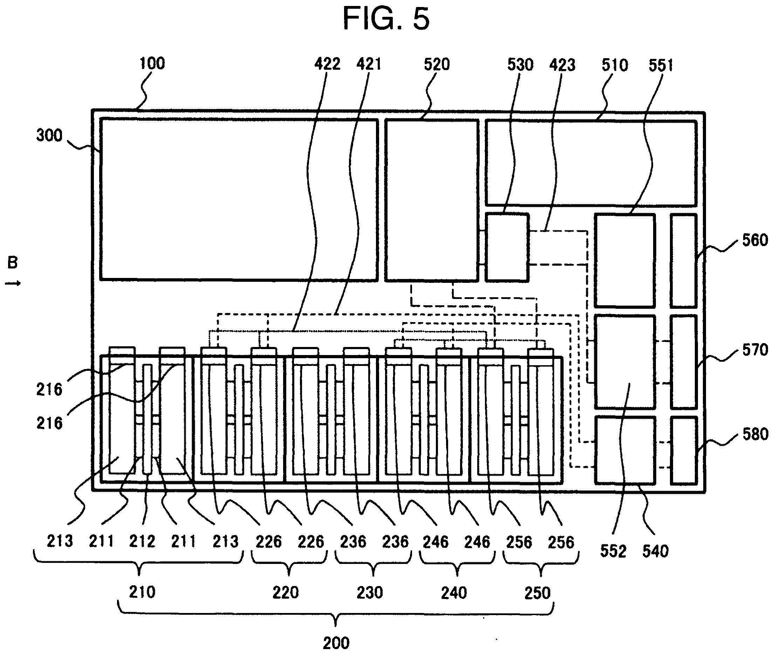

Next, the description will be made about a configuration of a main circuit wire for auxiliary power source. FIG. 5 is a plan view illustrating a configuration of the main circuit wire for auxiliary power source of the power conversion device according to the first embodiment of the invention. In the main circuit for auxiliary power source, the main circuit terminals 226 and 246 of the second power unit 220 and the fourth power unit 240 of a converter circuit are connected to a main circuit terminal 256 of the fifth power unit 250 through the DC wire 422, the DC is converted into the three-phase AC for an auxiliary machine in the fifth power unit 250 of an auxiliary power source circuit. The three-phase AC output from the fifth power unit 250 is supplied to the reactor 520 and the AC capacitor 530 through the three-phase AC wire 423, and connected to the auxiliary power source output terminal 570 through the auxiliary power source output core 552.

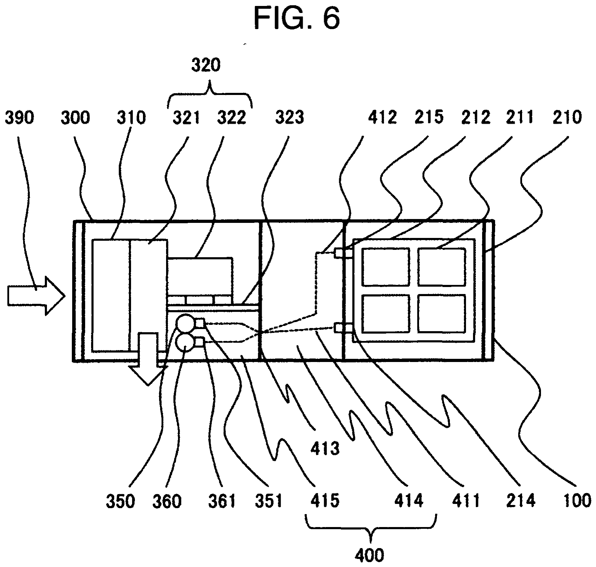

Next, a pipe path and a position of the wire connector will be described using the first power unit 210 as an example. FIG. 6 is a diagram illustrating a pipe path of the power conversion device according to the first embodiment of the invention when viewed in a direction of arrow A of FIGS. 2 and 3. The space 400 where the inlet-side pipe 411 and the outlet-side pipe 412 are provided is configured by an enclosed portion 414 and an opened portion 415 which are divided by the inner wall 413. A motor 322 of the air blower 320 is provided on a pedestal 323, and the distribution pipe 350 and the gathering pipe 360 are disposed in the opened portion 415 under the pedestal 323. The inlet-side pipe 411 connected to the inlet-side wire connector 214 of the first power unit 210 and the outlet-side pipe 412 connected to the outlet-side wire connector 215 are collected in the lower portion of the enclosed portion 414, and connected to the distributing-side wire connector 351 and the gathering-side wire connector 361 through a through hole provided in the inner wall 413. A gap between the inlet-side pipe 411 and the outlet-side pipe 412 and the through hole provided in the inner wall 413 is filled with putty, and the enclosed portion 414 is sealed with respect to the outside air. The other pipes connected to the power units 220, 230, 240, and 250 also have the same configuration.

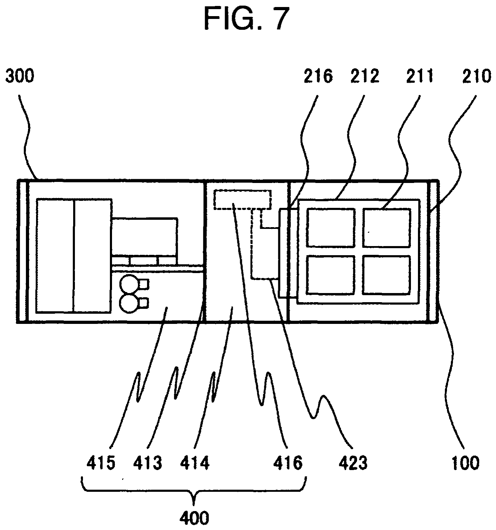

Next, the description will be made about a wire path using the first power unit 210 as an example. FIG. 7 is a diagram illustrating a wire path of the power conversion device according to the first embodiment of the invention when viewed in a direction arrow B of FIGS. 4 and 5. The three-phase AC wire 423 connected to the main circuit terminal 216 of the first power unit 210 is gathered in a wire installation space 416 which is provided in the upper portion in the enclosed portion 414, and connected to the motor output core 551 and the motor output terminal 560 through the wire installation space 416, so that the main circuit for motor driving illustrated in FIG. 4 is configured. The other wires connected to the power units 220, 230, 240, and 250 also have the same configuration.

Next, a flow of the cooling air in the cooling device 300 will be described. As illustrated in FIG. 6, a cooling air 390 is inhaled from the side surface of the power conversion device 100, and passes through the radiator 310 while exchanging heat with the liquid refrigerant. An impeller casing 321 of the air blower 320 is provided in the space between the radiator 310, the distribution pipe 350, and the gathering pipe 360. The cooling air passed through the radiator 310 passes through the impeller casing 321 and discharged from the bottom surface of the power conversion device 100.

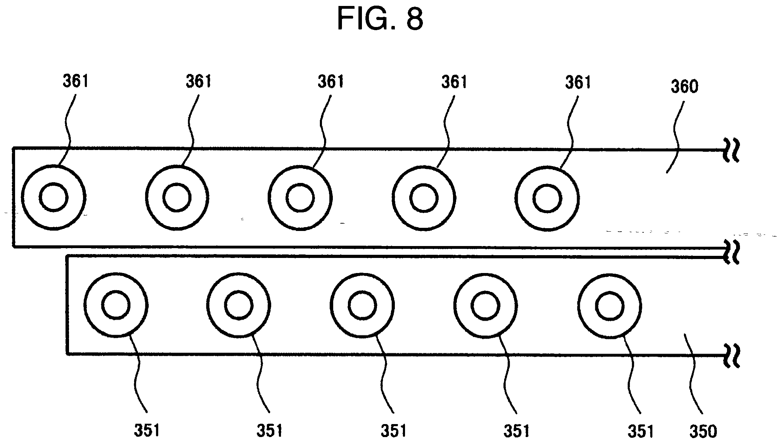

A position of the wire connector of the cooling device 300 will be described. FIG. 8 is a diagram illustrating a position of the wire connector of the cooling device which is mounted in the power conversion device according to the first embodiment of the invention when viewed in a direction of arrow C of FIGS. 2 and 3. In the first embodiment, the distribution pipe 350 is disposed below the gathering pipe 360. Five wire connectors 351 provided on the distribution pipe 350 and five wire connector 361 provided on the gathering pipe 360 are disposed in a staggered pattern.

Next, the description will be made about detaching of the power unit using the first power unit 210 as an example. When the first power unit 210 is removed from the power conversion device 100, the inlet-side wire connector 214 and the outlet-side wire connector 215 are removed from the first power unit 210, the DC wire 422 and the three-phase AC wire 423 are removed from the main circuit terminal 216, and further a control wire (not illustrated) connected to the control device 510 is removed from the first power unit 210, so that the first power unit 210 can be individually removed from the power conversion device 100. In addition, when installing, the inlet-side wire connector 214 and the outlet-side wire connector 215 are connected to the first power unit 210, the DC wire 422 and the three-phase AC wire 423 are connected to the main circuit terminal 216, and further the control wire is connected to the control device 510, so that the first power unit 210 can be individually installed into the power conversion device 100. In this way, the first power unit 210 is individually detachably attached with respect to the power conversion device 100. The other power units 220, 230, 240, and 250 are individually detachably attached.

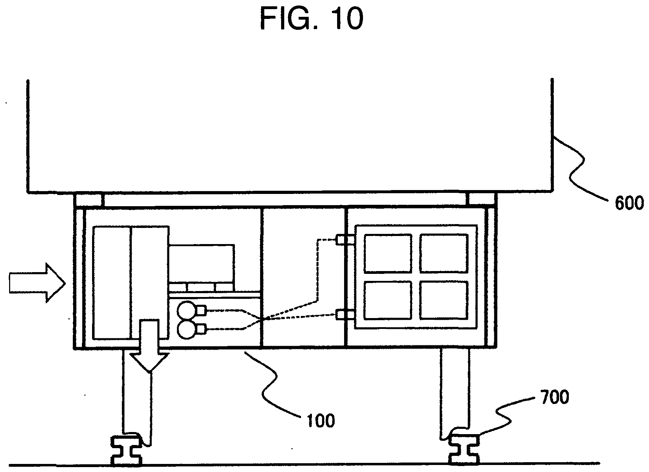

FIG. 10 is a cross-sectional view of a railway vehicle when viewed in an advancing direction. The power conversion device 100 is provided below the floor of a railway vehicle 600, and the cooling device 300 inhales the air from the side surface of the railway vehicle and discharges the air to the bottom surface of the railway vehicle. In addition, each power unit is disposed to be detachably attached to the side surface of the railway vehicle on the side to the cooling device 300.

Herein, the effect of the first embodiment will be described. In a case where a power conversion capacity of the power conversion device is large and the power conversion device is configured by a plurality of power units, diameters of the pipes and the wires become large, and the number thereof is increased. As described in the first embodiment, the space 400 is provided in the center portion of the power conversion device 100 and the pipes 411 and 412 and the wires 421, 422, and 423 requiring a large installation space are gathered in the space 400, so that a work space for connecting the pipes and the wires can be shaped, and the power conversion device 100 can be miniaturized.

In addition, when the cooling device 300 is maintained, the maintenance may start from the bottom surface of the power conversion device 100. The distributing-side wire connectors 351 to 355 and the gathering-side wire connectors 361 to 365 are provided in the bottom surface of the cooling device 300, and the inlet-side and outlet-side pipes 411 and 412 are connected to the wire connector through the lower portion of the space 400. Therefore, the work for detaching the pipes 411 and 412 from the cooling device 300 and detaching the cooling device 300 from the power conversion device 100 becomes easy, so that a maintenance performance can be improved. Furthermore, since the wire connectors 351 and 361 are disposed in a staggered pattern, the pipes 411 and 412 are easily detached from the bottom surface of the cooling device 300, so that the maintenance performance can be improved still more.

In addition, in the power conversion device 100, the motor output terminal 560, the auxiliary power source output terminal 570, and the input terminal 580 are desirably provided in the upper portion of the power conversion device 100 in consideration of a waterproof property. Therefore, as described in the first embodiment, since the wire path can be made shortest by gathering the wires 421 and 423 in the wire installation space 416 of the upper portion of the space 400, resistance and inductance of the wire can be reduced and the wire can be reduced in weight.

In addition, it is desirable that the cooling air be discharged from the bottom surface in order to extremely reduce the space where the cooling air passes in the power conversion device. As described in the first embodiment, the radiator 310 is disposed on a side near the side surface of the power conversion device 100, the air blower 320 is disposed in the rear surface thereof, and the impeller casing 321 of the air blower 320 is provided in the space between the radiator 310, the distribution pipe 350, and the gathering pipe 360. Therefore, the space in the cooling device 300 can be effectively used, and the power conversion device 100 can be miniaturized.

In addition, the liquid refrigerant can be easily injected or discharged from the side surface of the power conversion device 100 by providing the valve 370 of the cooling device 300 in a direction facing the side surface of the power conversion device 100. Therefore, the maintenance performance can be improved.

In addition, the maintenance performance can be improved by the configuration that a plurality of power units 200 can be individually detachably attached.

In addition, the first embodiment has a structure which is suitable to be provided below the floor of the railway vehicle. Therefore, it is possible to provide a power conversion device which is small and easy to maintain by being provided below the floor of the railway vehicle.

Further, the first embodiment has been described on an assumption that five power units 200 are mounted in the power conversion device 100. However, the number of power units 200 is not limited to "5". In addition, the configuration of the main circuit wire is also not limited to that illustrated in FIGS. 4 and 5. In addition, four semiconductor elements 211 are assumed to be provided in the side surface of the cooling plate 212 in FIGS. 6 and 7, but the number of semiconductor elements 211 is not limited thereto. In addition, the distribution pipe 350 and the gathering pipe 360 may be reversely disposed in the vertical direction.

Furthermore, an air filter may be provided on a windward side of the radiator as needed. In addition, it is desirable that the air blower be insulated against vibration from the radiator and the pedestal using an anti-vibration rubber.

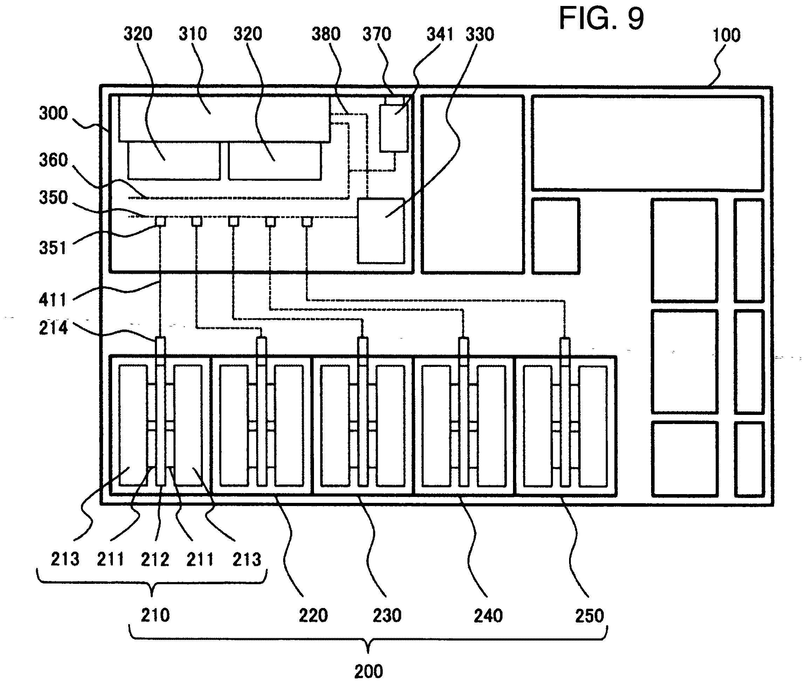

FIG. 9 is a plan view illustrating a configuration of a cooling device which is mounted in a power conversion device according to a second example of the invention. While the valve 370 and the expansion tank 340 are provided between the radiator 310 and the pump 330 in the first embodiment, a reservior tank 341 may be provided between the gathering pipe 360 and the radiator 310 as described in the second example, and the valve 370 may be provided in the upper portion of the reservior tank. In the first embodiment, it is considered that the liquid refrigerant is injected using an exterior pump from the valve. In the configuration as described in the second example, the liquid refrigerant can be injected into the flow channel by injecting the liquid refrigerant into the reservior tank. However, when degassing in the flow channel when the liquid refrigerant is injected is took into consideration, the reservior tank 341 of the second example is necessarily provided at the highest point of the liquid refrigerant flow channel.

## Claims

1. A power conversion device (100) comprising:
a plurality of power units (200), each of which is provided with a power conversion circuit;
a plurality of wires through which power is input and output with respect to the plurality of power units (200); and
a cooling device (300) that supplies a liquid refrigerant to the plurality of power units (200); and
a plurality of pipes that connect the plurality of power units (200) and the cooling device (300),
wherein a space (400) is provided in the center portion of the power conversion device (100) to gather the plurality of wires and the plurality of pipes,
main circuit terminals (216, 226, 236, 246) that connect the plurality of wires to the plurality of power units (200), a plurality of power-unit-side pipe connectors (214, 215) that connect the plurality of pipes to the plurality of power units (200), and a plurality of cooling-device-side pipe connectors (351, 361) that connect the plurality of pipes to the cooling device (300) are disposed at positions abutting on the space (400),
the plurality of cooling-device-side pipe connectors are provided in a bottom surface of the cooling device (300),
the plurality of pipes are connected to the plurality of cooling-device-side pipe connectors through a lower portion of the space (400) from the plurality of power-unit-side pipe connectors,
the plurality of wires are connected to an input and an output of the power conversion device (100) through an upper portion of the space (400) from main circuit terminals of the plurality of power units (200), and
the plurality of power units (200) are each configured to be detachably attached to the power conversion device (100).

2. The power conversion device (100) according to claim 1,
wherein the cooling device (300) is configured by a radiator (310) that cools down the liquid refrigerant, an air blower (320) that supplies a cooling air to the radiator (310), a pump (330) that circulates the liquid refrigerant, a distribution pipe (350) that divides and supplies the liquid refrigerant to the plurality of power units (200), and a gathering pipe (360) that receives the liquid refrigerant from the plurality of power units (200),
the plurality of cooling-device-side pipe connectors are provided in the distribution pipe (350) and the gathering pipe (360), and are provided in a bottom surface of the cooling device (300),
the air blower (320) is provided on a windward side of the radiator (310), and
the cooling air is supplied from a side surface of the power conversion device (100) to the radiator (310), passes through a space between the distribution pipe (350) and the gathering pipe (360), and is discharged from a bottom surface of the power conversion device (100).

3. The power conversion device (100) according to claim 2,
wherein the plurality of cooling-device-side pipe connectors provided in the distribution pipe (350) and the gathering pipe (360) are disposed in a staggered pattern.

4. The power conversion device (100) according to any one of claims 1 to 3,
wherein a valve (370) for injecting or discharging the liquid refrigerant to the cooling device (300) is provided in at least one place of a side surface and a bottom surface of the power conversion device (100).

5. The power conversion device (100) according to any one of claims 1 to 4,
wherein the power conversion device (100) is provided below a floor of a railway vehicle (600).

## Patentansprüche

1. Leistungswandlervorrichtung (100), umfassend:
eine Vielzahl von Leistungseinheiten (200), die jeweils mit einer Leistungswandlerschaltung bereitgestellt sind;
eine Vielzahl von Leitungen, durch die Leistung mit Bezug auf die Vielzahl von Leistungseinheiten (200) eingespeist und ausgegeben wird; und
eine Kühlvorrichtung (300), die der Vielzahl von Leistungseinheiten (200) ein flüssiges Kühlmittel zuführt; und
eine Vielzahl von Rohren, welche die Vielzahl von Leistungseinheiten (200) und die Kühlvorrichtung (300) verbindet,
wobei im Mittelabschnitt der Leistungswandlervorrichtung (100) ein Raum (400) bereitgestellt ist, um die Vielzahl von Leitungen und die Vielzahl von Rohren zu sammeln,
wobei Hauptschaltungsanschlüsse (216, 226, 236, 246), welche die Vielzahl von Leitungen mit der Vielzahl von Leistungseinheiten (200) verbinden, eine Vielzahl von leistungseinheitsseitigen Rohrverbindern (214, 215), welche die Vielzahl von Rohren mit der Vielzahl von Leistungseinheiten (200) verbinden, und eine Vielzahl von kühlvorrichtungsseitigen Rohrverbindern (351, 361), welche die Vielzahl von Rohren mit der Kühlvorrichtung (300) verbinden, an am Raum (400) anstoßenden Positionen angeordnet sind,
wobei die Vielzahl von kühlvorrichtungsseitigen Rohrverbindern in einer Unterseitenfläche der Kühlvorrichtung (300) bereitgestellt ist,
wobei die Vielzahl von Rohren mit der Vielzahl von kühlvorrichtungsseitigen Rohrverbindern durch einen unteren Abschnitt des Raums (400) von der Vielzahl von leistungseinheitsseitigen Rohrverbindern verbunden ist,
wobei die Vielzahl von Leitungen mit einem Eingang und einem Ausgang der Leistungswandlervorrichtung (100) durch einen oberen Abschnitt des Raums (400) von Hauptschaltungsanschlüssen der Vielzahl von Leitungseinheiten (200) verbunden ist und
wobei die Vielzahl von Leistungseinheiten (200) jeweils konfiguriert ist, an der Leistungswandlervorrichtung (100) lösbar angebracht zu sein.

2. Leistungswandlervorrichtung (100) gemäß Anspruch 1,
wobei die Kühlvorrichtung (300) durch einen Kühler (310), der das flüssige Kühlmittel abkühlen lässt, ein Luftgebläse (320), der dem Kühler (310) Kühlluft zuführt, eine Pumpe (330), die das flüssige Kühlmittel zirkulieren lässt, ein Verteilungsrohr (350), das das flüssige Kühlmittel aufteilt und der Vielzahl von Leistungseinheiten (200) zuführt, und ein Sammelrohr (360), welches das flüssige Kühlmittel von der Vielzahl von Leistungseinheiten (200) aufnimmt, konfiguriert ist,
wobei die Vielzahl von kühlvorrichtungsseitigen Rohrverbindern in dem Verteilungsrohr (350) und dem Sammelrohr (360) bereitgestellt ist, und in einer Unterseitenfläche der Kühlvorrichtung (300) bereitgestellt ist,
wobei das Luftgebläse (320) auf einer Luvseite des Kühlers (310) bereitgestellt ist, und
wobei die Kühlluft dem Kühler (310) von einer Seitenfläche der Leistungswandlervorrichtung (100) zugeführt wird, durch einen Raum zwischen dem Verteilungsrohr (350) und dem Sammelrohr (360) hindurchtritt und von der Unterseitenfläche der Leistungswandlervorrichtung (100) austreten gelassen wird.

3. Leistungswandlervorrichtung (100) gemäß Anspruch 2,
wobei die Vielzahl von in dem Verteilungsrohr (350) und dem Sammelrohr (360) bereitgestellten, kühlvorrichtungsseitigen Rohrverbindern in einem versetzten Muster angeordnet ist.

4. Leistungswandlervorrichtung (100) gemäß einem der Ansprüche 1 bis 3,
wobei ein Ventil (370) zum Einspritzen oder Austreten-Lassen des flüssigen Kühlmittels zur Kühlvorrichtung (300) hin an mindestens einer Stelle einer Seitenfläche und einer Unterseitenfläche der Leistungswandlervorrichtung (100) bereitgestellt ist.

5. Leistungswandlervorrichtung (100) gemäß einem der Ansprüche 1 bis 4,
wobei die Leistungswandlervorrichtung (100) unterhalb eines Bodens eines Schienenfahrzeugs (600) bereitgestellt ist.

## Revendications

1. Dispositif de conversion d'alimentation électrique (100) comprenant :
une pluralité d'unités d'alimentation électrique (200), chacune d'entre elles étant munie d'un circuit de conversion d'alimentation électrique ;
une pluralité de fils à travers lesquels une puissance est entrée et délivrée en sortie par rapport à la pluralité d'unités d'alimentation électrique (200) ; et
un dispositif de refroidissement (300) qui fournit un réfrigérant liquide à la pluralité d'unités d'alimentation électrique (200) ; et
une pluralité de tuyaux qui connectent la pluralité d'unités d'alimentation électrique (200) et le dispositif de refroidissement (300),
dans lequel un espace (400) est prévu dans la partie centrale du dispositif de conversion d'alimentation électrique (100) pour rassembler la pluralité de fils et la pluralité de tuyaux, et
des bornes de circuit principal (216, 226, 236, 246) qui connectent la pluralité de fils à la pluralité d'unités d'alimentation électrique (200), une pluralité de raccords de tuyau côté unité d'alimentation électrique (214, 215) qui raccordent la pluralité de tuyaux à la pluralité d'unités d'alimentation électrique (200) et une pluralité de raccords de tuyaux côté dispositif de refroidissement (351, 361) qui raccordent la pluralité de tuyaux au dispositif de refroidissement (300) sont disposés dans des positions de mise en butée sur l'espace (400),
la pluralité de raccords de tuyau côté dispositif de refroidissement sont prévus dans une surface inférieure du dispositif de refroidissement (300),
la pluralité de tuyaux sont raccordées à la pluralité de raccords de tuyau côté dispositif de refroidissement à travers une partie inférieure de l'espace (400) de la pluralité de raccords de tuyau côté unité d'alimentation électrique, et
la pluralité de fils sont connectés à une entrée et à une sortie du dispositif de conversion d'alimentation électrique (100) à travers une partie supérieure de l'espace (400) à partir des bornes de circuit principal de la pluralité d'unités d'alimentation électrique (200), et
la pluralité d'unités d'alimentation électrique (200) sont chacune configurées pour être attachées de manière amovible au dispositif de conversion d'alimentation électrique (100).

2. Dispositif de conversion d'alimentation électrique (100) selon la revendication 1,
dans lequel le dispositif de refroidissement (300) est configuré par un radiateur (310) qui refroidit le réfrigérant liquide, un ventilateur d'air (320) qui fournit un air de refroidissement au radiateur (310), une pompe (330) qui fait circuler le réfrigérant liquide, un tuyau de distribution (350) qui divise et fournit le réfrigérant liquide à la pluralité d'unités d'alimentation électrique (200), et un tuyau collecteur (360) qui reçoit le réfrigérant liquide de la pluralité d'unités d'alimentation électrique (200),
la pluralité de raccord de tuyau côté dispositif de refroidissement sont prévus dans le tuyau de distribution (350) et le tuyau collecteur (360), et sont prévus dans une surface inférieure du dispositif de refroidissement (300),
le ventilateur d'air(320) est prévu sur un côté au vent du radiateur (310), et
l'air de refroidissement est fourni au radiateur (310) depuis une surface latérale du dispositif de conversion d'alimentation électrique (100), passe à travers un espace entre le tuyau de distribution (350) et le tuyau collecteur (360), et est évacué depuis une surface inférieure du dispositif de conversion d'alimentation électrique (100).

3. Dispositif de conversion d'alimentation électrique (100) selon la revendication 2,
dans lequel la pluralité de raccords de tuyau côté dispositif de refroidissement prévus dans le tuyau de distribution (350) et le tuyau collecteur (360) sont disposés de manière étagée.

4. Dispositif de conversion d'alimentation électrique (100) selon l'une quelconque des revendications 1 à 3,
dans lequel une vanne (370) destinée à injecter ou à décharger le réfrigérant liquide vers le dispositif de refroidissement (300) est prévue au niveau d'au moins un endroit d'une surface latérale et d'une surface inférieure du dispositif de conversion d'alimentation électrique (100).

5. Dispositif de conversion d'alimentation électrique (100) selon l'une quelconque des revendications 1 à 4,
dans lequel le dispositif de conversion d'alimentation électrique (100) est prévu sous le plancher d'un véhicule ferroviaire (600).
